Europäisches Patentamt

European Patent Office

Office européen des brevets

(19)

(11) EP 0 708 447 B1

(12) FASCICULE DE BREVET EUROPEEN

(45) Date de publication et mention
de la délivrance du brevet:
**16.08.2000 Bulletin 2000/33**

(51) Int Cl.⁷: **G11C 5/00**

(21) Numéro de dépôt: **95402313.1**

(22) Date de dépôt: **17.10.1995**

(54) **Mémoire insensible aux perturbations**

Gegen Störungen unempfindlicher Speicher

Memory insensitive to disturbances

(84) Etats contractants désignés:
**CH DE FR GB IT LI NL**

(30) Priorité: **18.10.1994 FR 9412412**

(43) Date de publication de la demande:
**24.04.1996 Bulletin 1996/17**

(73) Titulaire: **THOMSON-CSF SEMICONDUCTEURS SPECIFIQUES**
**75008 Paris (FR)**

(72) Inventeurs:
• **Masson, Thierry**
  **F-92402 Courbevoie Cedex (FR)**
• **Ferrant, Richard**
  **F-92402 Courbevoie Cedex (FR)**

(74) Mandataire: **Guérin, Michel et al**
**Thomson-CSF Propriété Intellectuelle,**
**13, Avenue du Président Salvador Allende**
**94117 Arcueil Cédex (FR)**

(56) Documents cités:
**US-A- 5 157 625**

• **IBM TECHNICAL DISCLOSURE BULLETIN, vol. 30, no. 8, Janvier 1988 NEW YORK US, pages 248-249, XP 000049766 'TWICE REDUNDANT RADIATION HARDENED LATCH'**
• **PROCEEDINGS OF THE IEEE, vol. 76, no. 11, Novembre 1988 NEW YORK US, pages 1470-1509, XP 000100554 SHAFER ET AL 'THE DESIGN OF RADIATION HARDENED ICs FOR SPACE: A COMPENDIUM OF APPROACHES'**
• **IEEE TRANSACTIONS ON NUCLEAR SCIENCE, vol. 30, no. 6, Décembre 1983 NEW YORK US, pages 4501-4507, DIEHL ET AL 'CONSIDERATIONS FOR SINGLE EVENT IMMUNE VLSI LOGIC'**

**Description**

La présente invention concerne une mémoire en circuit intégré et plus particulièrement une mémoire du type registre dans laquelle l'information existe sous forme de deux niveaux logiques complémentaires se confirmant l'un l'autre.

De telles mémoires sont très sensibles à la perte d'information due à l'apport d'énergie venant de l'extérieur tel que, par exemple, l'apport d'énergie d'un ion lourd traversant le matériau semiconducteur au niveau de la jonction où l'un des deux niveaux logiques est stocké.

La jonction se comporte en effet comme une capacité que les paires électrons/trous créées lors de l'impact de l'ion lourd viennent charger. Si l'on note C la valeur de la capacité et $\Delta Q$ la variation de charge de la capacité résultant de l'impact, il s'en suit une variation de tension $\Delta V$ aux bornes de la capacité telle que $\Delta V = \Delta Q/C$.

La variation de tension $\Delta V$ peut alors atteindre un niveau tel que le niveau logique qui est stocké dans la jonction bascule, entraînant le basculement du niveau logique complémentaire. Les niveaux logiques complémentaires se confirmant l'un l'autre, il s'en suit que la cellule mémoire se trouve dans un état stable différent de l'état initial.

Les technologies actuelles permettent de réaliser des circuits dont les dimensions sont de plus en plus petites. La capacité C des jonctions peut alors atteindre des valeurs très faibles. Il s'en suit que la variation de tension $\Delta V$ atteint très souvent le seuil de basculement de l'information mémorisée pour une faible quantité de charges $\Delta Q$.

Différentes méthodes sont connues de l'homme de l'art pour remédier à cet inconvénient.

Une première méthode consiste à placer en série avec chaque jonction de capacité C une résistance R de façon que la constante de temps de chaque réseau RC ainsi constitué soit supérieure à la durée de la perturbation. Pour être efficace la résistance R doit alors atteindre des valeurs de l'ordre de 100 à 500 k$\Omega$. De telles valeurs sont difficiles à réaliser, notamment dans le cas des technologies actuellement les plus répandues et pour lesquelles le polysilicium qui sert à réaliser les grilles est recouvert de siliciure. Il est en effet alors nécessaire de retirer le siliciure pour pouvoir atteindre les valeurs élevées de résistances mentionnées ci-dessus. Une telle opération est très délicate et conduit à des rendements très faibles.

Une deuxième méthode consiste à ajouter des capacités sur les noeuds sensibles. La charge critique se trouve ainsi accrue et la variation de tension $\Delta V$ se trouve diminuée. Afin d'éviter d'agrandir la zone sensible aux perturbations, les capacités ajoutées ne doivent pas contenir de zone diffusée. La valeur des capacités s'en trouve désavantageusement limitée.

De façon plus générale, ces deux méthodes présentent d'autres inconvénients. Les résistances ou les capacités que l'on rajoute agrandissent très sensiblement les dimensions des cellules mémoire. D'autre part, les phases d'écriture se trouvent ralenties entraînant par la même la diminution des temps de maintien communément appelés "set-up" et "hold".

L'invention ne présente pas ces inconvénients.

On connaît par ailleurs, du document de brevet US 5,157,625, un circuit de mémoire résistant aux radiations, comprenant quatre sous-ensembles de quatre transistors chacun, les grilles des transistors d'une cellule constituant les entrées d'une cellule, reliées aux sorties de deux autres cellules, le tout en permutation circulaire, de manière à rétablir automatiquement l'état de la mémoire en cas de perturbation sur une seule cellule. Ce circuit occupe une place importante du fait qu'il comprend 20 transistors pour chaque cellule.

Ce document décrit les caractéristiques de la préambule de la revendication 1.

La présente invention a pour objet une cellule mémoire contenant l'information sous forme de deux niveaux logiques complémentaires stockés dans des noeuds différents avec des moyens de redondance pour stocker chaque niveau logique dans deux noeuds différents, la cellule comprenant quatre sous-ensembles de plusieurs transistors complémentaires en série entre une tension d'alimentation et une masse de la cellule, caractérisée en ce que chaque sous-ensemble est constitué d'un premier et d'un deuxième transistor, ledit premier transistor étant un transistor MOS de type P et ledit deuxième transistor étant un transistor MOS de type N, la source et le drain du premier transistor étant respectivement reliés à une tension d'alimentation et au drain du deuxième transistor, la source du deuxième transistor étant reliée à la masse de la cellule, la grille et le drain du premier transistor du sous-ensemble de rang i (i = 1, 2, 3) étant reliés respectivement au drain du premier transistor du sous-ensemble de rang i + 1 et à la grille du deuxième transistor du sous-ensemble de rang i + 1, la grille et le drain du premier transistor du sous-ensemble de rang 4 étant reliés respectivement au drain du premier transistor du sous-ensemble de rang 1 et à la grille du deuxième transistor de rang 1.

D'autres caractéristiques et avantages de l'invention apparaîtront à la lecture d'un mode de réalisation préférentiel fait avec référence aux figures ci-annexées parmi lesquelles :

- la figure 1 représente une cellule mémoire selon l'invention,
- les figures 2 et 3 représentent chacune une cellule mémoire selon l'invention dans le cas où la cellule mémoire comprend des commandes permettant d'initialiser son contenu.

Sur toutes les figures, les mêmes repères désignent les mêmes éléments.

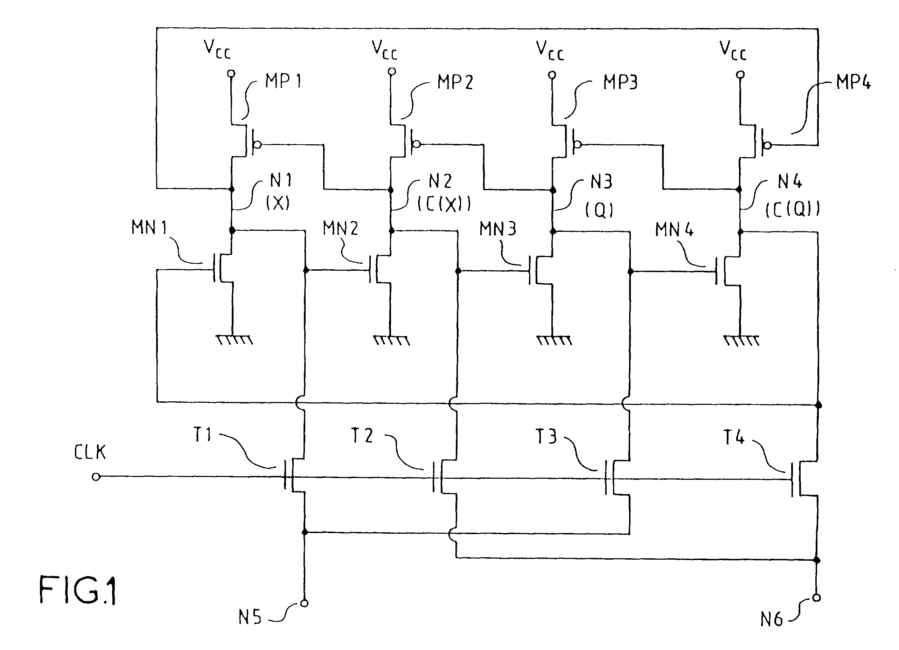

La figure 1 représente une cellule mémoire selon l'invention.

La cellule mémoire est constituée de quatre transistors MOS de type P, MP1, MP2, MP3, MP4 et de quatre transistors MOS de type N, MN1, MN2, MN3, MN4. Les sources des transistors MP1, MP2, MP3 et MP4 sont reliées à la tension d'alimentation Vcc, par exemple égale à + 5 volts, et les sources des transistors MN1, MN2, MN3 et MN4 sont reliées à la masse du circuit. Le drain du transistor MPi de rang (i = 1, 2, 3, 4) est relié au drain du transitor MNi.

La grille du transistor MPi (i = 1, 2, 3) est reliée au drain du transistor MP (i + 1), et la grille du transistor MP4 est reliée au drain du transistor MP1. De même, le drain du transistor MNi (i = 1, 2, 3), est relié à la grille du transistor MN (i + 1), et le drain du transistor MN4 est relié à la grille du transistor MN1.

Selon l'invention, l'information est stockée dans quatre noeuds N1, N2, N3, N4. Le noeud Ni (i = 1, 2, 3, 4) est le drain du transistor MPi.

Le noeud N1 contient l'information sous forme de niveau logique X. Il vient donc X = 1 ou X = 0.

Le noeud N2 contient l'information sous forme de niveau logique C(X), C(X) représentant le niveau logique complémentaire du niveau logique X. Il vient donc :

C(X) = 0 pour X = 1

C(X) = 1 pour X = 0.

Les noeuds N3 et N4 contiennent l'information sous forme des niveaux logiques respectifs Q et C(Q) avec Q = X et C(Q) = C(X).

Ainsi le circuit de l'invention permet-il de stocker un même niveau logique en 2 noeuds différents.

Sur la figure 1 ont aussi été représentés le signal d'horloge CLK ainsi que les quatre transistors MOS de type N T1, T2, T3, T4 permettant l'écriture des informations relatives aux noeuds respectifs N1, N2, N3 et N4. En ce qui concerne la lecture des informations stockées, elle peut soit s'effectuer aussi par l'intermédiaire des transistors T1, T2, T3, T4, soit s'effectuer par tout autre circuit connu de l'homme de l'art et permettant l'accès à la cellule mémoire.

Le noeud Ni (i = 1, 2, 3, 4) est relié au drain du transistor Ti. Les sources des transistors T1 et T3 sont reliées entre elles au même noeud d'accès N5 et les sources des transistors T2 et T4 sont reliées entre elles au même noeud d'accès N6.

A titre d'exemple, l'invention sera expliquée à partir d'une des deux configurations possibles de la cellule mémoire. Il s'agit de la configuration :

X = Q = 1

C(X) = C(Q) = 0

Dans cette configuration, les transistors MN1 et MN3 sont bloqués et les transistors MN2 et MN4 sont passants. De même, les transistors MP1 et MP3 sont passants, alors que les transistors MP2 et MP4 sont bloqués.

L'impact d'ions lourds sur les jonctions des transistors MN1 et MN3 conduit alors à des perturbations en tension d'amplitudes négatives sur les informations respectivement stockées aux noeuds N1 et N3.

De même, l'impact d'ions lourds sur les jonctions des transistors MP2 et MP4 conduit à des perturbations en tension d'amplitudes positives sur les informations respectivement stockées aux noeuds N2 et N4.

L'invention sera décrite, à titre d'exemple, dans le cas où l'impact d'ions lourds a lieu sur la jonction du transistor MN1. Compte tenu de la symétrie du montage, les conséquences de l'impact d'ions lourds sur les jonctions d'autres transistors aboutirait à des démonstrations du même type.

Comme cela a été mentionné précédemment, l'impact d'ions lourds sur la jonction du transistor MN1 conduit à une perturbation en tension d'amplitude négative. Cette perturbation peut ne pas entraîner de modification de l'état passant ou bloqué des différents transistors MPi et MNi (i = 1, 2, 3, 4) si son amplitude est faible. Le retour à l'état initial s'effectue alors naturellement. Si la perturbation est de grande amplitude, il est par contre possible que la chute de tension qui apparaît sur le noeud N1 entraîne le blocage du transistor MN2 et la mise en état passant du transistor MP4. Le blocage du transistor MN2 met alors le noeud N2 à haute impédance. Le niveau logique C(X) reste cependant à zéro, ce qui permet au transistor MP1 de rester passant et au transistor MN3 de rester bloqué.

La mise en état passant du transistor MP4 modifie la valeur de la tension qui s'applique au noeud N4 car il y a alors conflit entre MP4 et MN4. La valeur de la tension qui s'applique au noeud N4 est V(N4) telle que :

$$V(N4) = \frac{R(MP4)}{R(MP4)+R(MN4)} \times Vcc \, ,$$

R(MP4) et R(MN4) étant les valeurs des résistances présentées par les canaux respectifs des transistors MP4 et MN4 à l'état passant. Il s'en suit que la tension appliquée à la grille du transistor MP3 s'élève, ce qui a pour effet de rendre moins conducteur ce transistor. Cette modification de conduction du transistor MP3 peut même aller jusqu'à son blocage.

Le noeud N3 est haute impédance car le transistor MN3 est bloqué. Le niveau logique Q reste donc à 1 et le transistor MP2 reste bloqué. Comme le transistor MN2 est bloqué du fait de la perturbation, le niveau logique C(X) du noeud N2 demeure à zéro. Le transistor MP1 compense alors la perturbation par un retour du niveau logique X à 1. Les transistor MN2 et MP4 redeviennent alors respectivement passant et bloqué, replaçant ainsi la cellule dans son état stable initial.

Ainsi le niveau logique X retrouve-t-il sa valeur initiale 1 du fait du maintient à 0 du niveau logique C(X).

De façon plus générale, pour la configuration X = 1, C(X) = 0, Q = 1, C(Q) = 0, une perturbation sur le niveau C(X) conduit à un retour de ce niveau à 0 du fait du maintien à 1 du niveau X, une perturbation sur le niveau Q conduit à un retour de ce niveau à 1 du fait du maintien à 0 du niveau C(Q), et une perturbation sur le niveau C(Q) conduit à un retour de ce niveau à 0 du fait du maintien du niveau Q à 1.

De même, pour la configuration X = 0,C(X) = 1, Q = 0, C(Q) = 1, une perturbation sur le niveau X conduit à un retour de ce niveau à 0 du fait du maintien à 1 du niveau C(Q), une perturbation sur le niveau C(X) conduit à un retour de ce niveau à 1 du fait du maintien à 0 du niveau Q, une perturbation sur le niveau Q conduit à un retour de ce niveau 0 du fait du maintien à 1 du niveau C(X) et une perturbation sur le niveau C(Q) conduit à un retour de ce niveau à 1 du fait du maintien à 0 du niveau X.

Ainsi la cellule mémoire selon l'invention comprend-elle des moyens pour se replacer dans la configuration initiale qui précède la modification d'un niveau logique due à une perturbation, du fait du maintien à sa valeur de l'un des deux niveaux logiques complémentaires du niveau logique qui est modifié.

Un avantage de la cellule mémoire selon l'invention est de ne jamais autoriser le basculement de la cellule. Les dispositifs de l'art antérieur autorisent tous un basculement au-delà d'un certain niveau d'énergie de l'ion lourd. A titre d'exemple, en ce qui concerne les circuits de l'art antérieur à correction de type résistif, ce niveau d'énergie est sensiblement égal à 35 Mev/mg/cm$^2$ pour des valeurs de résistance égales à 500 kΩ. Cela conduit alors à des courants de l'ordre de 10 mA parcourant les jonctions. En ce qui concerne la cellule mémoire selon l'invention, il a été mesuré dans les jonctions des valeurs de courant de l'ordre de 20 A sans qu'il y ait de basculement. La cellule mémoire selon l'invention interdit donc le basculement de l'information quel que soit le niveau d'énergie atteint par les ions lourds.

La plupart des registres nécessitent l'emploi de commandes permettant d'initialiser rapidement le contenu des cellules mémoire.

Comme cela est connu de l'homme de l'art, deux types différents de commandes permettent d'initialiser une cellule mémoire.

Le premier type de commande est constitué des commandes $\overline{RESET}$ et $\overline{SET}$. La commande $\overline{RESET}$ force les niveaux logiques X et Q à 0 et la commande $\overline{SET}$ force les niveaux logiques C(X) et C(Q) à 0.

Le deuxième type de commandes est constitué des commandes RESET et SET. La commande RESET force les niveaux logiques C(X) et C(Q) à 1 et la commande SET force les niveaux logiques X et Q à 1.

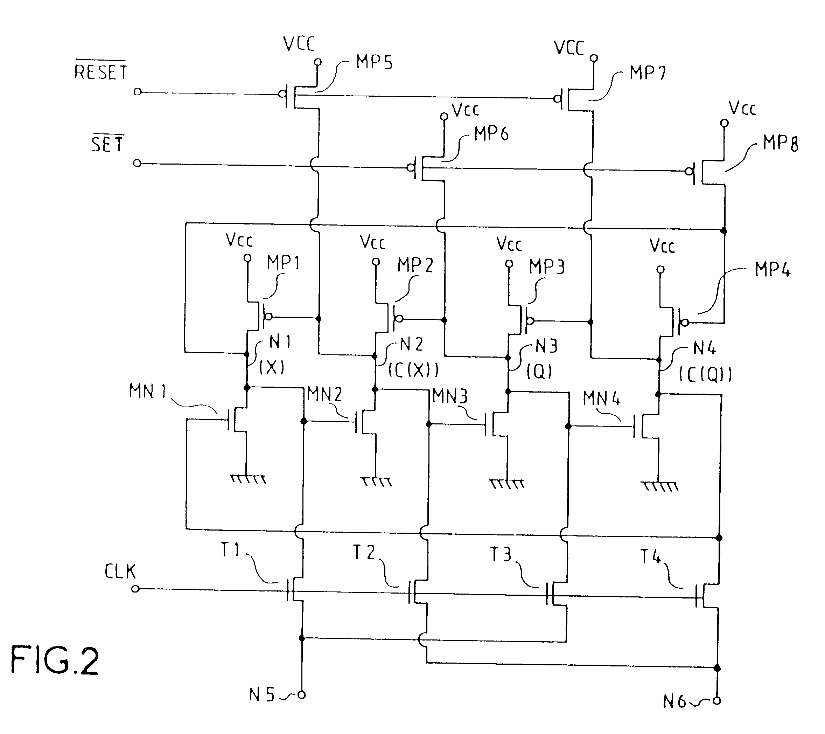

La figure 2 représente une cellule mémoire selon l'invention dans le cas où la mémoire comprend des commandes $\overline{SET}$ et $\overline{RESET}$.

La commande $\overline{SET}$ s'applique aux grilles de deux transistors MOS de type P, notés MP6 et MP8 sur la figure 2. Les drains des transistors MP6 et MP8 sont reliés à la même tension d'alimentation Vcc, la source du transistor MP6 et la source du transistor MP8 étant reliées respectivement aux noeuds N3 et N1 de la cellule mémoire.

De même la commande $\overline{RESET}$ s'applique aux grilles de deux transistors MOS de type P, notés MP5 et MP7. Les drains des transistors MP5 et MP7 sont reliés à la même tension d'alimentation Vcc, la source du transistor MP5 et la source du transistor MP7 étant reliées aux noeuds respectifs N2 et N4.

La commande $\overline{SET}$ = 0 force C(X )et C(Q) à 0 par l'intermédiaire des transistors respectifs MP8 et MP6. Le transistor MN2 étant passant et le transistor MP2 étant bloqué, il s'en suit que C(X) = 0. De même, le transistor MP4 étant passant et le transistor MP4 étant bloqué, il vient C(Q) = 0.

La commande $\overline{RESET}$ = 0 force, quant à elle, X et Q à 0 par l'intermédiaire des transistors respectifs MP5 et MP7.

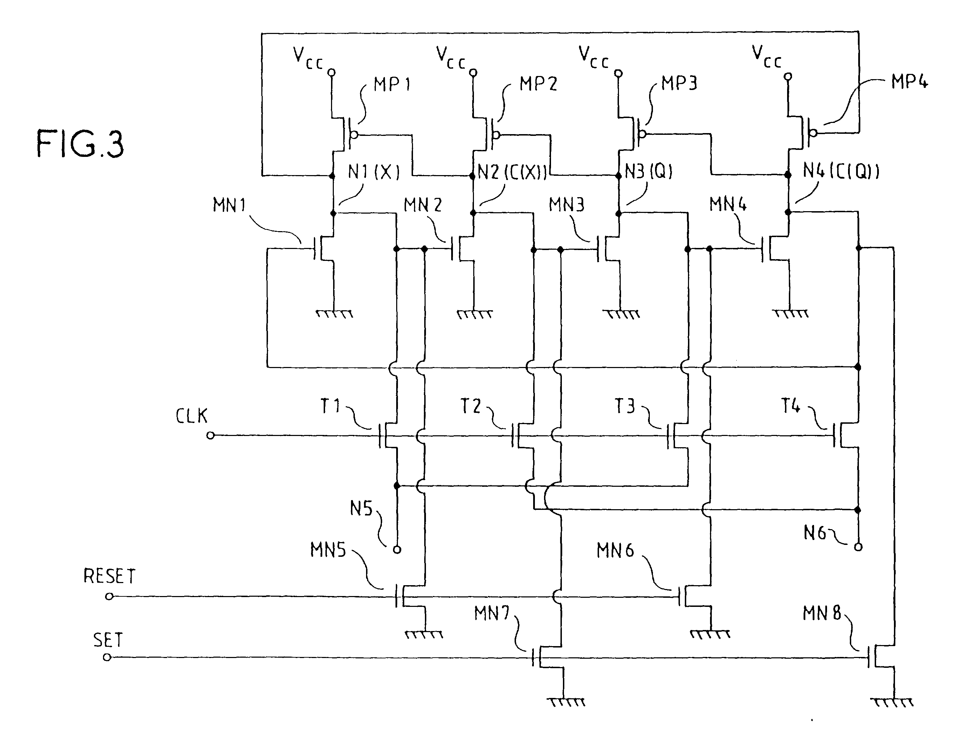

La figure 3 représente une cellule mémoire selon l'invention dans le cas où la mémoire comprend des commandes notées SET et RESET.

La commande SET s'applique aux grilles de deux transistors MOS de type N, MN7 et MN8 et la commande RESET aux grilles de deux transistors MOS de type N, MN5 et MN6. Les sources des transistors MN5, MN6, MN7, MN8 sont reliées à la masse du circuit. Les drains des transistors MN5, MN6, MN7, MN8 sont reliés, quant à eux, aux noeuds respectifs N1, N3, N2 et N4.

Un avantage de la cellule mémoire selon l'invention est d'assurer la réalisation des commandes SET et RESET ou $\overline{SET}$ et $\overline{RESET}$ de façon très simple.

L'usage de transistors MOS de type P pour les fonctions de SET et de RESET sera préféré dans le cas où il est nécessaire de réaliser des circuits à forte densité. En effet, selon ce mode de réalisation, le masque du circuit intégré est très facile à réaliser et peut alors être extrêmement dense car, comme cela apparaît en figure 2, il y a alors autant de transistors de type P que de transistors de type N.

**Revendications**

1. Cellule mémoire contenant l'information sous forme de deux niveaux logiques complémentaires stockés dans des noeuds différents avec des moyens de redondance pour stocker chaque niveau logique dans deux noeuds (N1, N2, N3, N4) différents, la cellule comprenant quatre sous-ensembles de plusieurs transistors complémentaires en série entre une tension d'alimentation et une masse de la cellule, caractérisé en ce que chaque sous-ensemble est constitué d'un premier et d'un deuxième transistor, ledit premier transistor (MPi) étant un transistor MOS de type P et ledit deuxième transistor (MNi) étant un transistor MOS de type N, la source et le drain du premier transistor étant respectivement reliés à une tension d'alimentation (+Vcc) et au drain du deuxième transistor du même sous-ensemble, la source du deuxième transistor étant reliée à la masse de la cellule, la grille et le drain du premier transistor du sous-ensemble de rang i (i = 1, 2, 3) étant reliés respectivement au drain du premier transistor du sous-ensemble de rang i + 1 et à la grille du deuxième transistor du sous-ensemble de rang i + 1, la grille et le drain du premier transistor du sous-ensemble de rang 4 étant reliés respectivement au drain du premier transistor du sous-ensemble de rang 1 et à la grille du deuxième transistor de rang 1.

2. Cellule mémoire selon la revendication 1, caractérisée en ce qu'elle comprend des moyens d'écriture de l'information stockée sur les drains desdits premier et deuxième transistors d'un même sous-ensemble de rang i (i = 1, 2, 3, 4), lesdits moyens étant constitués d'un transistor MOS Ti de type N dont le drain est relié aux drains desdits premier et deuxième transistors du sous-ensemble de rang i, les sources des transistors de rang 1 et 3 étant reliées entre elles à un même premier noeud d'accès (N5) et les sources des transistors de rang 2 et 4 étant reliées entre elles à un même deuxième noeud d'accès (N6).

3. Cellule mémoire selon la revendication 1 ou 2, caractérisée en ce qu'elle comprend des moyens permettant d'initialiser son contenu.

4. Cellule mémoire selon la revendication 3, caractérisée en ce que les moyens permettant d'initialiser son contenu sont constitués de deux transistors MOS (MP6, MP8) de type P dont les grilles sont reliées entre elles et à une même commande $\overline{SET}$, dont les drains sont reliés à la même tension d'alimentation (+Vcc) et dont les sources sont respectivement reliées l'une aux drains desdits premier et deuxième transistors du même sous-ensemble de rang 2, l'autre aux drains desdits premier et deuxième transistor du même sous-ensemble de rang 4, et de deux transistors MOS (MP5, MP7) de type P dont les grilles sont reliées entre elles et à une même commande $\overline{RESET}$, dont les drains sont reliés entre eux à ladite tension d'alimentation et dont les sources sont respectivement reliées l'une aux drains desdits premier et deuxième transistors du même sous-ensemble de rang 1, l'autre aux drains desdits premier et deuxième transistors du même sous-ensemble de rang 3.

5. Cellule mémoire selon la revendication 3, caractérisée en ce que les moyens permettant d'initialiser son contenu sont constitués de deux transistors MOS (MN7, MN8) de type N dont les grilles sont reliées entre elles et à une même commande (SET), dont les sources sont reliées à la masse du circuit, et dont les drains sont respectivement reliés l'un aux drains desdits premier et deuxième transistors du même sous-ensemble de rang 2, l'autre aux drains desdits premier et deuxième transistor du même sous-ensemble de rang 4, et de deux transistors MOS (MN5, MN6) de type N dont les grilles sont reliées entre elles et à une même commande (RESET), dont les sources sont reliées à la masse du circuit, et dont les drains sont respectivement reliés l'un aux drains desdits premier et deuxième transistors du même sous-ensemble de rang 1, l'autre aux drains desdits premier et deuxième transistor du même sous-ensemble de rang 3.

**Patentansprüche**

1. Speicherzelle, die Informationen in Form von zwei zueinander komplementären und in unterschiedlichen Knoten gespeicherten logischen Pegeln enthält, mit Redundanzmitteln, um jeden logischen Pegel in zwei unterschiedlichen Knoten (N1, N2, N3, N4) der Zelle zu speichern, wobei die Zelle vier Untereinheiten von je mehreren komplementären Transistoren in Reihe zwischen einer Speisespannung und einem Massepotential der Zelle enthält, dadurch gekennzeichnet, daß jede Untereinheit aus einem ersten und einem zweiten Transistor besteht, von denen der erste (MPi) ein MOS-Transistor vom Typ P und der zweite (MNi) ein MOS-Transistor vom Typ N ist, daß der Source- und der Drainanschluß des ersten Transistors mit einer Speisespannung (+Vcc) beziehungsweise mit dem Drainanschluß des zweiten Transistors der gleichen Untereinheit verbunden sind, daß der Sourceanschluß des zweiten Transistors auf dem Massepotential der Zelle liegt, daß der Gateanschluß und der Drainanschluß des ersten Transistors der Untereinheit des Rangs i (i = 1, 2, 3) mit dem Drainanschluß des ersten Transistors der Untereinheit des Rangs i+1 beziehungsweise dem Gateanschluß des zweiten Transistors der Untereinheit des Rangs i+1 verbunden sind und daß der Gateanschluß und der Drainanschluß des ersten Transistors der Untereinheit des Rangs 4 mit dem Drainanschluß des ersten Transistors der Untereinheit des Rangs 1 beziehungsweise mit dem Gateanschluß des zweiten Transistors des Rangs 1 verbunden sind.

2. Speicherzelle nach Anspruch 1, dadurch gekennzeichnet, daß sie Mittel zum Ausschreiben der auf den Drainanschlüssen des ersten und des zweiten Transistors einer Untereinheit des Rangs i (i = 1, 2, 3, 4) gespeicherten Information enthält, wobei diese Mittel von einem MOS-Transistor des Typs N gebildet werden, dessen Drainanschluß mit den Drainanschlüssen des ersten und des zweiten Transistors der Untereinheit des Rangs i verbunden ist, während die Sourceanschlüsse der Transistoren des Rangs 1 und des Rangs 3 gemeinsam mit einem ersten Zugangsknoten (N5) und die Sourceanschlüsse der Transistoren des Rangs 2 und des Rangs 4 gemeinsam mit einem zweiten Zugangsknoten (N6) verbunden sind.

3. Speicherzelle nach Anspruch 1 oder 2, dadurch gekennzeichnet, daß sie Mittel zur Initialisierung ihres Inhalts aufweist.

4. Speicherzelle nach Anspruch 3, dadurch gekennzeichnet, daß die Mittel zur Initialisierung ihres Inhalts aus zwei MOS-Transistoren (MP6, MP8) des Typs P, deren Gateanschlüsse gemeinsam mit einer Steuerung $\overline{SET}$, deren Drainanschlüsse mit der gemeinsamen Speisespannung (+Vcc) und deren Sourceanschlüsse mit den Drainanschlüssen des ersten und zweiten Transistors der gemeinsamen Untereinheit des Rangs 3 beziehungsweise mit den Drainanschlüssen des ersten und des zweiten Transistors der gemeinsamen Untereinheit des Rangs 1 verbunden sind, und aus zwei MOS-Transistoren (MP5, MP7) des Typs P bestehen, deren Gateanschlüsse gemeinsam mit einer Steuerung $\overline{RESET}$, deren Drainanschlüsse mit der gemeinsamen Speisespannung und deren Sourceanschlüsse mit den Drainanschlüssen des ersten und zweiten Transistors der gemeinsamen Untereinheit des Rangs 2 beziehungsweise mit den Drainanschlüssen des ersten und des zweiten Transistors der gemeinsamen Untereinheit des Rangs 4 verbunden sind.

5. Speicherzelle nach Anspruch 3, dadurch gekennzeichnet, daß die Mittel zur Initialisierung ihres Inhalts aus zwei MOS-Transistoren (MN7, MN8) des Typs N, deren Gateanschlüsse gemeinsam mit einer Steuerung (SET), deren Sourceanschlüsse mit der Masse der Schaltung und deren Drainanschlüsse mit den Drainanschlüssen des ersten und des zweiten Transistors der gemeinsamen Untereinheit des Rangs 2 beziehungsweise mit den Drainschlüssen des ersten und des zweiten Transistors der gemeinsamen Untereinheit des Rangs 4 verbunden sind, und aus zwei MOS-Transistoren (MP5, MP6) des Typs N bestehen, deren Gateanschlüsse gemeinsam mit einer Steuerung (RESET), deren Sourceanschlüsse mit der Masse der Schaltung und deren Drainanschlüsse mit den Drainanschlüssen des ersten und des zweiten Transistors der gemeinsamen Untereinheit des Rangs 1 beziehungsweise mit den Drainanschlüssen des ersten und des zweiten Transistors der gleichen Untereinheit des Rangs 3 verbunden sind.

**Claims**

1. Memory cell containing information in the form of two complementary logical levels stored in different nodes with redundancy means for storing each logical level in two different nodes (N1, N2, N3, N4), the cell comprising four subassemblies having a plurality of complementary transistors in series between a power supply voltage and a cell earth, characterised in that each subassembly is composed of a first and second transistor, said first transistor (MPi) being a P type MOS transistor and said second transistor (MNi) being an N type MOS transistor, the source and drain of the first transistor being connected respectively to a power supply voltage (+Vcc) and to the drain of the second transistor of the same subassembly, the source of the second transistor being connected to the cell earth, the gate and the drain of the first transistor in the subassembly of index i (i = 1, 2, 3) being connected respectively to the drain of the first transistor in the subassembly of index i+1 and to the gate of the second transistor in the subassembly of index i+1, the gate and the drain of the first transistor in the subassembly of index 4 being connected respectively to the drain of the first transistor in the subassembly of index 1 and to the gate of the second transistor of index 1.

2. Memory cell according to claim 1, characterised in that it comprises means of writing information stored on the drains of said first and second transistors in the same subassembly of index i (i = 1, 2, 3, 4), said means being composed of an N type Ti MOS transistor the drain of which is connected to the drains of said first and second transistors in the subassembly of index i, the sources of the transistors of indices 1 and 3 being connected to each other at a first access node (N6) and the sources of the transistors of indices 2 and 4 being connected to each other and to a second access node (N7).

3. Memory cell according to claim 1 or 2, characterised in that it comprises means enabling its contents to be initialised.

4. Memory cell according to claim 3, characterised in that the means enabling its contents to be initialised consist of two P type MOS transistors (MP6, MP8), the gates of which are connected to each other and to one SET control the drains of which are connected to the same power supply voltage (+Vcc) and the sources of which are respectively connected to the drains of said first and second transistors in the same subassembly of index 2 and to the drains of said first and second transistors in the same subassembly of index 4, and by two P type MOS transistors (MP5, MP7) the drains of which are connected to each other and to one RESET control, the drains of which are connected to each other at said power supply voltage and the sources of which are respectively connected to the drains of said first and second transistors in the same subassembly of index 1 and to the drains of said first and second transistors in the same subassembly of index 3.

5. Memory cell according to claim 3, characterised in that the means enabling its contents to be initialised are composed of two N type MOS transistors (MN7, MN8) the gates of which are connected to each other and to one and the same (SET) control, the sources of which are connected to the circuit earth, and the drains of which are respectively connected to the drains of said first and second transistors in the same subassembly of index 2 and the other to the drains of said first and second transistors in the same subassembly of index 4, and of two N type MOS transistors (MN5, MN6) the gates of which are connected to each other and to one and the same (RESET) control the sources of which are connected to the circuit earth, and the drains of which are respectively connected to the drains of said first and second transistors in the same subassembly of index 1, and to the drains of said first and second transistors in the same subassembly of index 3.

FIG.1

FIG.2

FIG.3

EP 0 708 447 B1